# EUROPEAN PATENT APPLICATION

(11) **EP 4 836 590 A1**
(43) Date of publication of application: **04.11.2026**
(21) Application number: 25173259.0
(22) Date of filing: 29.04.2025
(51) Int. Cl.: H05B 45/18, H05B 45/28, H05B 45/30, H05B 45/50, H05B 45/44, H05B 47/105

(54) **DRIVING UNIT FOR LED- AND MOTOR-CONTROL OF AUTOMOTIVE HEADLAMPS**

(71) Applicant: Melexis Technologies NV, 3980 Tessenderlo-Ham (BE)
(72) Inventor: LAUTE, Andreas, 99099 Erfurt (DE); FREITAG, Thomas, 99099 Erfurt (DE); OTT, Andreas, 99099 Erfurt (DE)
(74) Representative: Bardehle Pagenberg Partnerschaft mbB Patentanwälte Rechtsanwälte

(57) **Abstract**

A driving unit (100) for controlling a headlamp of a vehicle is described. The driving unit comprises at least one light emitting diode, LED, driver (115a, 115b, 115c) configured to be connectable to one or more LEDs (400a-1 to 400a-n, 400b-1 to 400b-n, 400c-1 to 400c-n); at least one motor driver (110) connected to the at least one LED driver and configured to be connectable to one or more electric motors (500); and a first terminal (120) connected to the LED driver and configured to be connectable to a vehicle controller (200) and configured to receive information associated with a lighting scenario from the vehicle controller; wherein the at least one LED driver is configured to: receive the information associated with the lighting scenario via the first terminal, drive the one or more LEDs in accordance with the lighting scenario, and instruct the at least one motor driver to drive the one or more electric motors in accordance with the lighting scenario. Further, a system comprising a corresponding driving unit and a vehicle head lamp is described, the vehicle head lamp comprising the one or more LEDs, which are configured to be connected to the LED driver of the driving unit, and one or more electric motors, which are configured to be connected to the motor driver.

## Description

### TECHNICAL FIELD

The invention of the current patent application relates to control of headlamps in automotive applications.

### BACKGROUND

In modern automotive headlamp systems, light emitting diodes (LEDs) are used as light source. LEDs provide bright light and have a high lifetime and can be adjusted to provide light of a particular color. Usually, in an automotive headlamp, a plurality of LEDs is used to generate light. The individual LEDs of the plurality of LEDs are typically arranged in a matrix-type arrangement, which means that an array is formed by the individual LEDs. As used herein, an array may be an arrangement of (m x n) LEDs, wherein m and n are integers ≥ 1. Without loss of generality, a row of the array may be formed by a string comprising multiple LEDs. An LED array of (1 x n) may also be referred to as an LED string. In order to have the LED array producing light of a desired kind, control of the individual LEDs is necessary, thereby setting brightness and color parameters (if multi-color LEDs are used). The LEDs in a row or a string may be connected in series or may be connected in parallel, e.g. realized by subgroups of LEDs, the subgroups being connected in parallel. Different rows in an array may be connected in parallel, but could also be connected in series with a defined wrap indicating the end of a row.

Furthermore, in modern automotive headlamp systems, the light generated by the LEDs is not only controlled by controlling the individual LEDs themselves, but also additional elements such as motors (e.g. for shuttering, leveling, swiveling, or ventilation), matrix managers (e.g. for adaptive driving functionality), or sensors (e.g. temperature sensors), among others are also involved in the generation of light with modern automotive headlamps.

Due to the involvement of different elements, which may be provided by a plurality of manufacturers, oftentimes a variety of different communication standards may be used to provide communication between the different elements. Usually, these communication standards include Ethernet or bus system communications. Some examples of commonly used bus systems are Local Interconnect Network (LIN), Control Area Network (CAN), Serial Peripheral Interface (SPI), Universal Asynchronous Receiver Transmitter (UART), and Inter-Integrated Circuit (I²C or I2C). Among these, some communication standards may generally be preferred for the communication between the main control of the vehicle (e.g. LIN, CAN, UART, or Ethernet), while some communication standards may generally be preferred for the communication between the LED control and peripheral devices, such as the LEDs or the aforementioned motors (e.g. SPI, UART, or I2C bus systems). The skilled person will appreciate that these examples of communication systems are identified for illustrative purposes only and that the scope of the current patent application is not limited to any one of these communication systems.

Hence, there is a need in the art for reliable driving units for automotive headlamps with a simple and cost-efficient structure.

### SUMMARY

The abovementioned need is addressed by a driving unit for automotive headlamps according to the invention. The invention is defined by the independent claims. Preferred embodiments are set out in the dependent claims.

A driving unit according to the invention comprises at least one light emitting diode (LED) driver, at least one motor driver and a first terminal.

The at least one LED driver is configured to be connectable to one or more LEDs. The one or more LEDs are generally not part of the LED driver. The one or more LEDs may comprise a terminal and the LED driver may comprise another terminal in order to enable connecting said LED to the LED driver. The LEDs and the LED driver may be soldered on a substrate. An example of a substrate may be a printed circuit board (PCB). In some embodiments, the LEDs and the LED driver may be soldered on the same substrate. The connection between the respective terminals of the LED driver and the one or more LEDs may be via dedicated wires or, if the LEDs and the LED driver are soldered on the same substrate, via tracks on the substrate. In some preferred embodiments, the one or more LEDs may be formed by an LED string. The one or more LEDs may be single-color LEDs or may be multi-color LEDs.

In some applications, a plurality of LEDs may be connected to the at least one LED driver and the plurality of LEDs may be arranged in a matrix-type arrangement. In some examples, two or more LED drivers may be provided, and an LED string may be connected to each of the two or more LED drivers. For example, in such an arrangement, an individual string may represent one of the rows of the matrix-type arrangement and the columns of the matrix-type arrangement are formed by LEDs of the different strings. For example, a (3 x n)-matrix-type arrangement may be formed by three LED strings, each LED string having n LEDs, wherein each LED string may preferably be connected to one of the LED drivers. An LED string may be divided into LED segments. In addition to the control of the LED performed by the LED driver, a matrix manager may provide control of the brightness (e.g. dimming) of the LEDs. The matrix manager may be an external component, it may be a component of the driving unit or it may be integrated into one of the LED drivers. In some embodiments, each LED driver is connected to a string of LEDs and a matrix manager may be integrated into each LED driver, wherein said matrix manager is configured to control the brightness of the LED string connected to the respective LED driver. In case that the matrix manager is for controlling the brightness of an LED string, the matrix manager may also be referred to as a string manager.

The at least one motor driver is connected to the at least one LED driver. The at least one motor driver may be connected to the at least one LED driver via a signal interface. The signal interface may be circuitry (e.g. wired or etched) or may be an internal bus system of the driving unit. Further the at least one motor driver may be configured to be connectable to one or more electric motors. The electric motors may provide adjustments to the position or motion of the one or more LEDs and/or may provide other functions, such as operating a fan ventilation for cooling the LEDs. This way, the at least one electric motor may provide any combination of shuttering, leveling, swiveling or ventilation. For example, shuttering refers to the act of operating a beam shutter for one or more LEDs, which means opening/closing or moving a light shade relative to the one or more LEDs. In some examples, a mirror may be used to manipulate the light that is outputted by the automotive lamp. The one or more electric motors may be used to move the motor by a translational motion, a tilting motion or a combination thereof. This way, the light output of the automotive lamp may be adjusted by moving the mirror. In some examples in which the LEDs are soldered to a substrate (e.g. a PCB), the light output may be adjusted by moving the substrate. Similar to the mirror, the substrate may be moved by translation, tilting or a combination thereof. All these examples, either individually or in combination, may be used to alter the light beam generated by one or more LEDs or may be used to switch between high beam and low beam of an automotive headlamp.

In contrast, leveling and swiveling refers to changing the orientation or position of the one or more LEDs, which may for example be used to adjust the generated light beam to the load of the vehicle or to couple the generated light with a steering direction of the vehicle.

Lastly, ventilation may be used to control the temperature of the LEDs. This may be used to avoid LED malfunction due to overheating or to keep the temperature stable at a desired setpoint in order reduce temperature shift of the generated light.

These operations that may be performed by the at least one electric motor are examples of operations that are beneficial for operating automotive LED headlamps, but this list of operations is not exhaustive, and the operation of the electric motor is not limited to these operations. Examples of electric motors that may be used to achieve the desired functions are DC motors, brushless DC (BLDC) motors, or stepper motors.

In any case, the intended operation of the electric motors is controlled by the at least one motor driver, which means that the at least one motor driver instructs the one or more electric motors.

The first terminal is connected to the LED driver. The first terminal may be connected to the LED driver via a signal interface. The signal interface may be circuitry (e.g. wired or etched) or may be an internal bus system of the driving unit. The signal interface may be the same signal interface as the one connecting the LED driver and the motor driver or it may be another signal interface. The first terminal may be configured to be connectable to a vehicle controller. A vehicle controller in the sense of the current application is an element of the vehicle that is not a part of the driving unit - in other words, the vehicle controller is an external component relative to the driving unit. The vehicle controller may be the main control of the vehicle or a sub-entity of the main control. Further, the vehicle controller is used to address the driving unit in order to synchronize operation of the headlamp and the status of the vehicle - for example, when a vehicle operator turns on the headlamp, the vehicle controller will issue a command that is transmitted to the LED driver of the headlamp via the first terminal. In other words, the first terminal provides for communication between a vehicle controller and the driving unit by providing a connection between the vehicle controller and the LED driver. The first terminal may be configured to be connectable to the vehicle controller by one or more of a variety of bus systems, including a LIN, CAN, UART, UART over CAN or ethernet.

As mentioned, the first terminal may be configured to represent a connection of the driving unit with one or more external components. Further, the first terminal is configured to receive information associated with a lighting scenario from a vehicle controller. Here, the term lighting scenario refers to an instance or a sequence of lighting of the one or more LEDs. For example, a string of LEDs may generate a light spot moving from one end of the string of LEDs to the other end in a sequential manner. This may, for example, be achieved by controlling the LEDs in a manner that the first LED of the string is turned on for a certain amount of time, while all other LEDs are turned off. Said certain amount of time may be referred to as frame duration and the instance during which the first LED is on and the others are off may be referred to as frame. Afterwards, i.e. during a second frame, the first LED is turned off, the second LED is turned on and all other LEDs are turned off. In a third frame, the first two LEDs are turned off, the third LED is turned on and all other LEDs are turned off, and so on. The skilled person will appreciate that the light moving from one end of an LED string to another end of the LED string represents a rather simple example of a lighting scenario and that the driving unit is also configured to generate arbitrary other lighting scenarios.

In another example of a lighting scenario, multiple LED strings are connected to multiple LED drivers. The LED driver may act to simultaneously switch all LEDs of the multiple LED strings on/off.

In another example of a lighting scenario, the at least one LED driver may receive a signal indicative of opposing traffic, e.g. signal obtained from a camera, and the at least one LED driver may selectively switch off/on some of the LEDs based on the signal indicative of opposing traffic. Thereby, an adaptive headlamp may be provided. The signal indicative of opposing traffic may be provided by the vehicle controller to the LED driver via the first terminal.

Further, the skilled person will appreciate that in addition to switching LEDs on/off, the LED driver may adjust the brightness of the LED. The adjustment of brightness may represent intermediate states that are traversed upon switching an LED on/off or the adjustment of brightness may be performed instead of fully switching off an LED.

According to the invention, the at least one LED driver is configured to receive the information associated with the lighting scenario via the first terminal, to drive the one or more LEDs in accordance with the lighting scenario, and to instruct the at least one motor driver to drive the one or more electric motors in accordance with the lighting scenario.

This way, the at least one LED driver receives information about the lighting scenario that is to be generated and controls both the lighting generated by the LEDs and the motor operations of the additional components, such as shuttering, leveling, swiveling or ventilation. In some embodiments, the at least one LED driver is configured to determine how the one or more LEDs and the motor operations are to be performed and drives the LEDs and instructs the at least one motor driver accordingly. In this case, the LED driver has control over the lighting scenario and instructs to the motor driver and peripheral components (e.g. the LEDs) as necessary to create the lighting scenario.

In other embodiments, the at least one LED driver receives information that can be directly used to control the LED operation and the motor operations - e.g. the LED driver may receive the instructions that are used to instruct the motor driver without a need for having the LED driver determining the instructions from the information associated with the lighting scenario itself. In this case, the vehicle controller has the control over the lighting scenario and provides the LED driver with instructions that the LED driver can directly apply to control the LEDs or that the LED driver can pass to the motor driver.

The disclosed invention has the benefit that the structure of the driving unit is simple - i.e. minimum configuration of LED driver, motor driver and first terminal for connection to external/peripheral components - while at the same time being capable of controlling complex lighting scenarios by operating LEDs and driving motor operations (e.g. shuttering, leveling, swiveling, or ventilation).

In other words, since the LED driver performs the controlling functionality of the lighting scenario, no additional components such as microcontrollers are necessary.

In addition, the LED driver may also perform diagnosing functions when performing motor driver control. For example, the LED driver may obtain sensor data provided by the motor driver, the sensor data being associated with the electric motor or the motor driver, and the LED driver may use the obtained information for determining the instructions for the motor driver.

In the following, preferred embodiments of the driving unit according to the invention will be described in more detail.

In some preferred embodiments the at least one LED driver, the at least one motor driver, and the signal interface between the motor driver and the LED driver may be packaged in a semiconductor package. Packing the components of the driving unit in a semiconductor package has the advantage that the driving unit is provided in a ready-to-use configuration that can easily be installed in the desired location within the vehicle. Furthermore, packaging the components of the driving unit protects them from environmental influences, such as dust, and improves longevity. The at least one LED driver, the at least one motor driver, and the signal interface between the motor driver and the LED driver may be packaged in a common semiconductor package or subgroups of these components may be packaged in individual semiconductor packages.

Further, in some preferred embodiments of the packaged driving unit, the at least one LED driver may be located on a first integrated circuit within the common semiconductor package, and the at least one motor driver may be located on a second integrated circuit within the common semiconductor package. Both integrated circuits may be connected by ease of wires, interfaces, or a bus system.

Alternatively, in some other preferred embodiments of the packaged driving unit, the at least one LED driver and the at least one motor driver may be located on a common integrated circuit within the semiconductor package. Providing the LED driver and the motor driver on the same integrated circuit may have the advantage that the structure of the driving unit is even more simplified since the components are located on a single chip.

In these examples, the connections provided by the integrated circuit may form the signal interface between the respective components.

In some embodiments, the at least one LED driver configured to instruct the at least one motor driver to drive the one or more electric motors in accordance with the lighting scenario is configured to instruct the motor driver to cause one or more of a leveling motion, a swiveling motion, a shuttering or a ventilation by the electric motor.

In some embodiments, the driving unit may comprise a second terminal connected to the LED driver and configured to be connectable to at least one matrix manager. A matrix manager may be used to control brightness and/or color of an individual LED. For example, if an array of LEDs is arranged in a matrix-type manner, the matrix manager may turn off individual LEDs within the array. This may, for example be done by shorting one or more LEDs. Accordingly, the at least one LED driver may further be configured to instruct said matrix manager to control at least one of the one or more LEDs in accordance with the lighting scenario. In some embodiments, controlling the LEDs may be performed by shorting one or more of the LEDs.

In some embodiments, the at least one LED driver may comprise a matrix manager configured to be connectable to the one or more LEDs. In other words, the function of the matrix manager may be integrated into one of the LED drivers. Compared to having a matrix manager as a peripheral component, the total number of components is decreased, which makes the headlamp controlling system more simple. Compared to having a matrix manager as a separate component within the driving unit, the structure of the driving unit may be simplified by integrating the matrix manager into the LED driver.

The operation of the matrix manager may be based on a lighting scenario controlled by the driving unit.

In some embodiments, the at least one LED driver may be further configured to receive temperature data from one or more temperature sensors. Further, the driving the one or more LEDs in accordance with the lighting scenario, the instructing the at least one motor driver to drive the one or more electric motors in accordance with the lighting scenario or both, when performed by the LED driver, may be based on the temperature data. The temperature data may be temperature data of one or more of the LEDs or a temperature of the environment in a perimeter of the LEDs. Oftentimes, the behavior of LEDs is influenced by the temperature under which they are operating. Since said temperature may change during operation - for example due to environmental conditions or by exhaust heat generated by the LED emitting light - it may be necessary to make adjustments to the control of the LEDs during operation. This may be achieved by determining the temperature and taking the temperature into account for the operation of driving the one or more LEDs. Furthermore, in some embodiments, the motor driver may be configured to drive a motor that is associated with ventilation. By ease of ventilation, the temperature may be reduced.

Temperature data may be provided in a number of different ways. In some embodiments, the driving unit may comprise one or more third terminals configured to be connectable to one or more temperature sensors. A third terminal may be a general-purpose input/output. Further, the temperature data may be provided from the one or more temperature sensors via the one or more third terminals.

In some other embodiments, the driving unit may comprise one or more temperature sensors. These temperature sensors may be integrated into the driving unit and may be connected to the at least one LED driver in order to enable the temperature sensors to provide the temperature data to the at least one LED driver.

In some other embodiments, the at least one motor driver may be configured to obtain the temperature data from the one or more electric motors. For example, the electric motors may comprise one or more temperature sensors. Additionally or alternatively, the temperature may be obtained from the electric motor itself. For example, the electric motor may comprise a sensor, in which case the temperature data may be provided as part of diagnose data, or the electric motor may comprise a coil and the temperature of the coil may be determined.

In some embodiments, the driving unit may comprise one or more third terminals configured to be connectable to one or more binning resistors. Generally, a binning resistor may be used to for adjusting parameters of the one or more LEDs. For example, a binning resistor may be used to set one or more LEDs to a particular base level light output. A base level light output may refer to the optical domain, i.e. a base level brightness or a base level color, or the base level light output may refer to the electrical domain, i.e. a base level voltage or a base level current. Further, a plurality of binning resistors may be used to align the respective base level light outputs of multiple LEDs. Adjusting the base level light outputs may be necessary in case that LEDs of different type are used or to account for tolerances in LEDs of a same type. The base level light output may be associated with a particular color of the LED. For example, a particular base level voltage or current may be associated with a particular color, such that changes in the base level voltage/current change the color of the light output of the LED. When calibrating the driving unit and the LEDs, binning resistors may be used to improve calibration. Additionally or alternatively, the instructions for the motor driver provided by an LED driver may be based on the binning resistors.

The third terminals connectable to the one or more binning resistors may be general-purpose inputs/outputs. Further, the at least one LED driver may be configured to read data from the one or more binning resistors via the one or more third terminals, and the driving the one or more LEDs in accordance with the lighting scenario, the instructing the at least one motor driver to drive the one or more electric motors in accordance with the lighting scenario or both, when performed by the LED driver, may be based on the data that the LED driver read from the one or more binning resistors.

In some embodiments, the at least one LED driver may be configured to provide diagnostic data to the vehicle controller. As mentioned above, there are various ways for the LED driver to obtain diagnostic data, e.g. by reading sensor data from the LEDs, the motor driver or the electric motor or another external component. In some embodiments, the diagnostic data may be provided to the vehicle controller and the vehicle controller may provide additional instructions based on the diagnostic data. However, in some embodiments, the LED driver may process the diagnostic data, may detect a potential issue and control the LEDs and/or the motor driver based on the diagnostic data in order to counteract the issue and avoid malfunction. In some embodiments, the LED driver may determine a fault tolerant time (FTT) and based on the FTT may determine whether the LED driver may decide how to control the LED/motor itself or whether the vehicle controller is to decide.

Furthermore, the abovementioned need is also fulfilled by a system comprising a driving unit according to the invention and a vehicle headlamp. The driving unit may be any of the driving units described above.

### BRIEF DESCRIPTION OF THE DRAWINGS

The following description and the annexed figures set forth in detail certain illustrative aspects of the driving unit described above. These aspects are indicative, however, of but a few of the various ways in which the principles of various embodiments can be employed and the described embodiments are intended to include all such aspects and their equivalent.

In the figures, like reference characters generally refer to the same parts throughout the different figures. The figures are not necessarily to scale. Instead, a general focus is put on an explanation of the universal principles of the invention.

In the following description, various embodiments of the invention are described with reference to the following figures:
- FIG. 1: shows a diagram illustrating an embodiment example of a driving unit according to the present invention;
- FIG. 2: shows a diagram illustrating another embodiment example of a driving unit according to the present invention.

### DETAILED DESCRIPTION

The following detailed description refers to the accompanying figures that show, by way of illustration, specific details and embodiments in which the invention may be practiced.

The word "exemplary" is used herein to mean "serving as an example, instance, or illustration". Any embodiment or design described herein as "exemplary" is not necessarily to be construed as preferred or advantageous over other embodiments or designs.

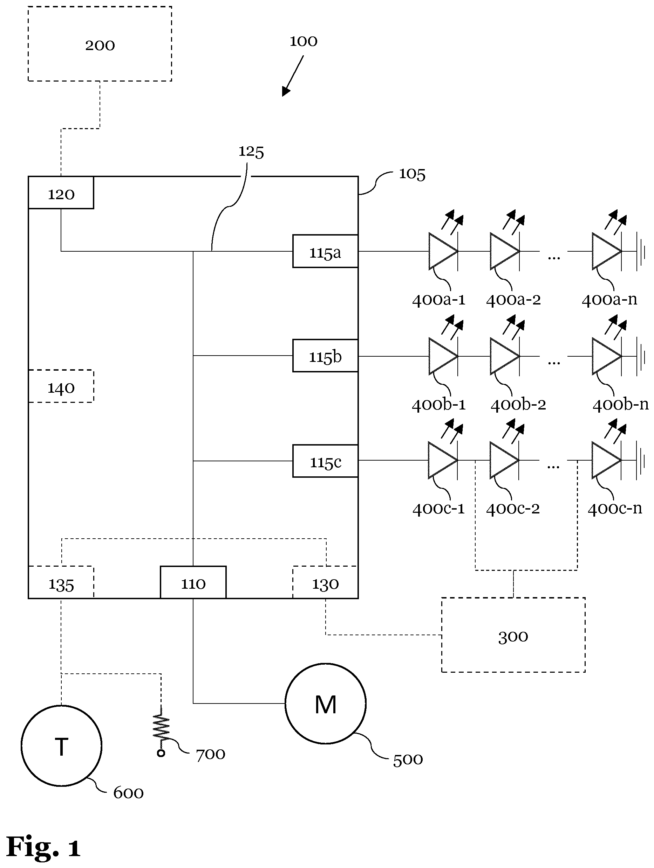

Figure 1 shows a diagram illustrating an embodiment example of a driving unit according to the present invention.

A driving unit according to the invention is generally shown at 100. The driving unit 100 is connected to a vehicle controller 200 via a first terminal 120. Via the first terminal 120, the vehicle controller 200 and the driving unit 100 may exchange data, such as diagnostic data, instructions, and/or information about lighting scenarios.

The driving unit 100 further comprises an LED driver 115; in figure 1, three LED drivers 115a, 115b, 115c are shown for illustrative purposes, but any number of LED drivers is possible. Each LED driver 115a, 115b, 115c is connected to an LED string 400. In figure 1, three LED strings are shown, wherein each LED string is connected to one of the LED drivers 115a, 115b, 115c and comprises a series of n individual LEDs 400a-1 to 400a-n, 400b-1 to 400b-n, 400c-1 to 400c-n.

Further, the driving unit 100 comprises a motor driver 110, which is connected to a motor 500.

Within the driving unit 100, the first terminal 120, the LED drivers 115a, 115b, 115c, and the motor driver 110 are connected with each other via a signal interface 125. The signal interface 125 may be circuitry (e.g. wired or etched) or may be an internal bus system of the driving unit 100. Furthermore, the signal interface 125 may be split into several interfaces (not shown), wherein one interface connects the first terminal 120 and one or more of the LED drivers 115a, 115b, 115c and another interface connects the motor driver and one or more of the LED drivers 115a, 115b, 115c.

Optionally, the driving unit 100 may comprise a second terminal 130 that is connectable to a matrix manager 300. The matrix manager may be a peripheral component and may be used to influence one or more LEDs of the LED strings. As illustrated in the figure, the matrix manager 300 may, for example, be configured to control the brightness of one or more of the LEDs 400c-1 to 400c-n.

Optionally, the driving unit 100 may comprise one or more third terminals 135, which may be general-purpose input/outputs. The one or more third terminals 135 may be connected to one or more temperature sensors 600 and/or one or more binning resistors 700.

Further, the driving unit 100 may comprise a power source connection 140.

The elements of the driving unit 100, i.e. the first terminal 120, the one or more LED drivers 115a, 115b, 115c, the motor driver 110 and the signal interface 125, the second terminal 130, the third terminal(s) 135 and power source connection 140, if present, may be packaged in a semiconductor package 105. Within the semiconductor package 105, the components may be placed on one or more integrated circuits. Alternatively, the components of the driving unit may be packaged in multiple interconnected packages.

In the figure, optional components and connections are illustrated in dashed lines.

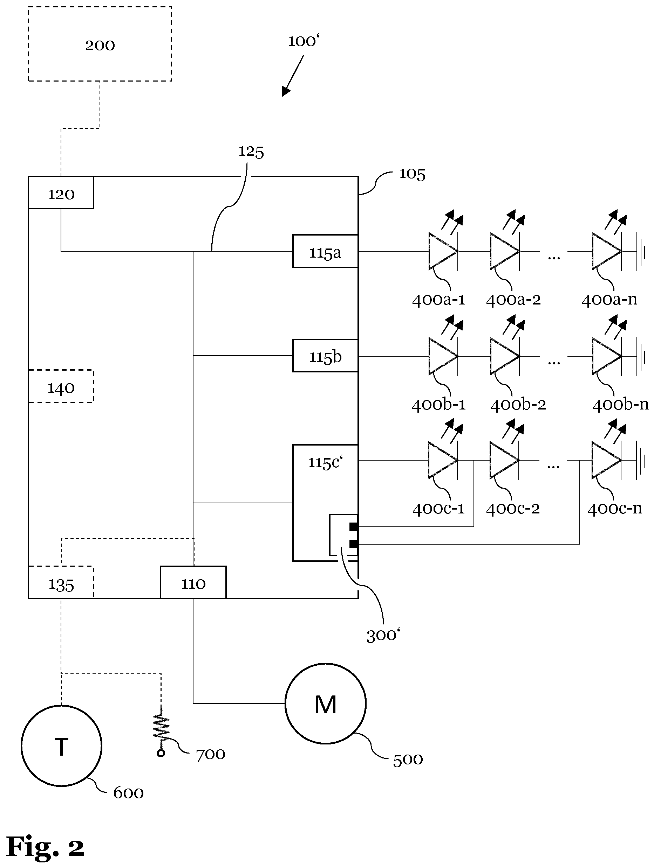

Figure 2 shows a diagram illustrating another embodiment example of a driving unit according to the present invention.

The driving unit 100' illustrated in figure 2 is similar to the driving unit 100 illustrated in figure 1. Therefore, only the differences will be explained in detail. Compared to the embodiment example of figure 1, the driving unit 100' illustrated in figure 2 comprises an LED driver 115c' with integrated matrix manager 300'. This means that besides being configured to drive the LED string 400c-1 to 400c-n, the LED driver 115c' also comprises the functionality of a matrix manager, e.g. the same functionality as matrix manager 300 illustrated in figure 1. This means that the LED driver 115c' may, for example, be configured to adjust the brightness of one or more of the LEDs 400c-1 to 400c-n.

What has been described above includes examples of one or more embodiments. It is, of course, not possible to describe every conceivable combination of components or methodologies for purposes of describing the aforementioned embodiments, but one of ordinary skill in the art may recognize that many further combinations and permutations of various embodiments are possible. Accordingly, the described embodiments are intended to embrace all such alterations, modifications and variations that fall within the scope of the appended claims.

## Claims

1. A driving unit (100, 100') for controlling a headlamp of a vehicle, the driving unit (100, 100') comprising:
at least one light emitting diode, LED, driver (115a, 115b, 115c, 115c') configured to be connectable to one or more LEDs;
at least one motor driver (110) connected to the at least one LED driver and configured to be connectable to one or more electric motors (500); and
a first terminal (120) connected to the LED driver (115a, 115b, 115c, 115c') and configured to be connectable to a vehicle controller (200) and
configured to receive information associated with a lighting scenario from the vehicle controller (200);
wherein the at least one LED driver (115a, 115b, 115c, 115c') is configured to:
receive the information associated with the lighting scenario via the first terminal (120);
drive the one or more LEDs in accordance with the lighting scenario; and
instruct the at least one motor driver (110) to drive the one or more electric motors (500) in accordance with the lighting scenario.

2. The driving unit according to claim 1, wherein the at least one LED driver is further configured to determine instructions for the at least one motor driver (110) to drive the one or more electric motors (500) in accordance with the lighting scenario.

3. The driving unit according to any of the aforementioned claims, wherein the at least one LED driver (115a, 115b, 115c, 115c'), the at least one motor driver (110), and the first terminal (120) are packaged in a semiconductor package.

4. The driving unit according to claim 3, wherein the at least one LED driver (115a, 115b, 115c, 115c') is located on a first integrated circuit within the semiconductor package; and
wherein the at least one motor driver (110) is located on a second integrated circuit within the semiconductor package.

5. The driving unit according to claim 3, wherein the at least one LED driver (115a, 115b, 115c, 115c') and the at least one motor driver (110) are located on a common integrated circuit within the semiconductor package.

6. The driving unit according to any of the aforementioned claims, wherein the at least one LED driver (115a, 115b, 115c, 115c') configured to instruct the at least one motor driver (110) to drive the one or more electric motors (500) in accordance with the lighting scenario instructs the motor driver (110) to cause one or more of a leveling motion, a swiveling motion, a shuttering or a ventilation by the electric motor (500).

7. The driving unit according to any of the aforementioned claims, further comprising:
a second terminal (130) connected to the LED driver (115a, 115b, 115c, 115c') and configured to be connectable to at least one matrix manager (300); and
wherein the at least one LED driver (115a, 115b, 115c, 115c') is further configured to instruct said matrix manager (300) to control at least one of the one or more LEDs in accordance with the lighting scenario.

8. The driving unit according to any of claims 1 to 6, wherein the at least one LED driver (115a, 115b, 115c, 115c') comprises a matrix manager (300') configured to be connectable to the one or more LEDs.

9. The driving unit according to any of the aforementioned claims,
wherein the at least one LED driver (115a, 115b, 115c, 115c') is further configured to receive temperature data from one or more temperature sensors (600); and
wherein the driving the one or more LEDs in accordance with the lighting scenario, the instructing the at least one motor driver (110) to drive the one or more electric motors (500) in accordance with the lighting scenario or both, when performed by the LED driver (115a, 115b, 115c, 115c'), are based on the temperature data.

10. The driving unit according to claim 9, further comprising one or more third terminals (135) configured to be connectable to one or more temperature sensors (600); and
wherein the temperature data is provided from the one or more temperature sensors (600) via the one or more one or more third terminals (135).

11. The driving unit according to claim 9, further comprising one or more temperature sensors (600).

12. The driving unit according to claim 9, wherein the temperature data is associated with the one or more electric motors (500) and wherein the at least one motor driver (110) is configured to obtain the temperature data from the one or more electric motors (500) and provide the temperature data to the at least one LED driver (115a, 115b, 115c, 115c'), or
wherein the temperature data is associated with the one or more LEDs and wherein the LED driver (115a, 115b, 115c, 115c') is configured to obtain the temperature data from the one or more LEDs.

13. The driving unit according to any of the aforementioned claims, further comprising one or more third terminals (135) configured to be connectable to one or more binning resistors (700);
wherein the at least one LED driver (115a, 115b, 115c, 115c') is further configured to read data from the one or more binning resistors (700) via the one or more third terminals (135); and
wherein the driving the one or more LEDs in accordance with the lighting scenario, the instructing the at least one motor driver (110) to drive the one or more electric motors (500) in accordance with the lighting scenario or both, when performed by the LED driver (115a, 115b, 115c, 115c'), are based on the data that the LED driver (115a, 115b, 115c, 115c') read from the one or more temperature sensors.

14. The driving unit according to any of the aforementioned claims, the at least one LED driver (115a, 115b, 115c, 115c') is configured to provide diagnostic data to the vehicle controller (200).

15. A system comprising:
a driving unit (100, 100') according to any of claims 1 to 14; and
a vehicle head lamp comprising the one or more LEDs, which are configured to be connected to the LED driver (115a, 115b, 115c, 115c') of the driving unit (100, 100'), and one or more electric motors (500), which are configured to be connected to the motor driver (110).
